# EUROPEAN PATENT APPLICATION

(11) **EP 4 818 357 A1**
(43) Date of publication of application: **07.10.2026**
(21) Application number: 26158905.5
(22) Date of filing: 16.02.2026
(51) Int. Cl.: C23C 14/04, C23C 14/24, C23C 14/56, H10K 71/16

(54) **DEPOSITION MATERIAL COLLECTING SPRAY DEVICE AND DEPOSITION DEVICE HAVING THE SAME**

(30) Priority: 04.04.2025 KR 20250044301
(71) Applicant: Samsung Display Co., Ltd., Yongin-si, Gyeonggi-do (KR)
(72) Inventor: LEE, Jongyoon, Yongin-si (KR); JEONG, Seongwoo, Yongin-si (KR); NOH, Sokwon, Yongin-si (KR)
(74) Representative: Marks & Clerk LLP

(57) **Abstract**

A spray device includes: a crucible configured to accommodate a deposition material; a device frame on the crucible; a nozzle in the device frame and configured to spray the deposition material toward a substrate; and a recovery unit in the device frame and configured to recover the deposition material spattering in directions other than the direction toward the substrate.

## Description

### BACKGROUND

Aspects of embodiments of the present disclosure relate to a deposition material recovering (or collecting) spray device, a deposition device including the same, and an electronic device including a display panel manufactured by the deposition device.

Generally, electronic devices, which provide images to users, such as a smartphone, a digital camera, a laptop computer, a navigation system, and a smart television, include a display device for displaying the images. The display device generates an image and provides the users with the generated image through a display screen.

The display device includes a display panel including a plurality of pixels for generating an image. Each of the pixels includes a light emitting element and a plurality of transistors that are connected to the light emitting element. The light emitting element is driven by the transistors to generate light.

The light emitting element includes an anode, a cathode, and an emission layer that is disposed between the anode and the cathode. Holes and electrons are injected into the emission layer from the anode and the cathode, respectively, to form excitons, and the light emitting elements emit light as the excitons transition to the ground state. When the light emitting elements of pixels are manufactured, a mask is placed on the substrate, and a deposition material for forming an emission layer through the openings of the mask is provided on the substrate.

After the mask is aligned with the substrate, a deposition process for depositing the deposition material on the substrate is performed. The deposition material is sprayed onto the substrate through the spray apparatus. During this process, some of the deposition material may scatter in directions other than the direction of the substrate, which causes waste of the deposition material.

### SUMMARY

Embodiments of the present disclosure provide a spray device that prevents waste of a deposition material by recovering the deposition material that spatters in directions other than a direction of a substrate and allows repurification and reuse of the deposition material, a deposition device including the same, and an electronic device including a display panel manufactured by the deposition device.

According to an embodiment of the present disclosure, a spray device includes a crucible configured to accommodate a deposition material, a device frame on the crucible, a nozzle in the device frame and configured to spray the deposition material in a direction toward a substrate, and a recovery unit in the device frame and configured to recover the deposition material spattering in directions other than the direction toward the substrate.

According to an embodiment of the present disclosure, a deposition device includes a chamber, a substrate stage in an interior of the chamber and configured to affix a substrate, a mask under the substrate stage and configured to guide a position in which a deposition material is deposited on the substrate, a barrier plate under the mask, a spray device under the barrier plate and configured to spray the deposition material in a direction toward the substrate, and a movement unit connected to the spray device and configured to move the spray device, the spray device being configured to recover the deposition material spattering in directions other than the direction toward the substrate.

According to an embodiment of the present disclosure, an electronic device includes a processor and a display device configured to receive an image signal from the processor and to provide a user with an image corresponding to the image signal. The display device includes a display panel manufactured by a deposition device including: a chamber, a substrate stage in an interior of the chamber and configured to affix substrate, a mask under the substrate stage and configured to guide a position in which a deposition material is deposited on the substrate, a barrier plate under the mask, a spray device under the barrier plate and configured to spray the deposition material in a direction toward the substrate and to recover the deposition material spattering in directions other than the direction toward the substrate, and a movement unit connected to the spray device and configured to move the spray device.

At least some of the above and other features of the invention are set out in the claims.

### BRIEF DESCRIPTION OF DRAWINGS

The above and other aspects and features of the present disclosure will become apparent by describing, in detail, embodiments thereof with reference to the accompanying drawings, in which:
FIG. 1 is a schematic view of a deposition device and a spray device according to an embodiment of the present disclosure.
FIG. 2 is a front view of a spray device according to an embodiment of the present disclosure.
FIG. 3 is a plan view illustrating a spray device according to an embodiment of the present disclosure.
FIG. 4 is a partial perspective view of a spray device according to an embodiment of the present disclosure.
FIG. 5 is a schematic view of the spray device shown in FIG. 1 with a front side device frame removed and including a recovery unit.
FIG. 6 is an enlarged view of the spray device and the recovery unit shown in FIG. 5.
FIGS. 7A to 7G illustrate experimental data illustrating a film thickness of a deposition material along a lengthwise direction of a substrate according to a recovery interval value disclosed in FIG. 6.
FIG. 8 is a view illustrating a state in which a deposition material is provided onto a substrate by a deposition device illustrated in FIG. 1.
FIG. 9 is a block diagram describing an electronic device according to an embodiment of the present disclosure.
FIG. 10 illustrates schematic views of various electronic devices according to various embodiments.
FIG. 11 is an exploded perspective view of an electronic device including a display panel manufactured by using a deposition device illustrated in FIG. 1.
FIG. 12 is a plan view of the display panel illustrated in FIG. 11.
FIG. 13 is a view illustrating a cross section of any one pixel illustrated in FIG. 12 according to an embodiment.

### DETAILED DESCRIPTION

In the specification, when one component (or area, layer, part, or the like) is referred to as being "on", "connected to", or "coupled to" another component, it should be understood that the former may be directly on, connected to, or coupled to the latter and also may be on, connected to, or coupled to the latter via a third intervening component.

The same reference numerals refer to the same components. Furthermore, in drawings, the thickness, ratio, and dimension of components may be exaggerated for effectiveness of description of technical contents.

The term "and/or" includes one or more combinations of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

Although the terms "first", "second", etc. may be used to describe various components, the components should not be construed as being limited by the terms. The terms are only used to distinguish one component from another component. For example, without departing from the scope of the present disclosure, a first component may be referred to as a second component, and similarly, the second component may be referred to as the first component. The articles "a" and "an" are singular in that they have a single referent, but the use of the singular form in the specification should not preclude the presence of more than one referent.

Also, the terms "under", "beneath", "on", "above", etc. are used to describe a relationship between components illustrated in a drawing. The terms are relative and are described with reference to a direction indicated in the drawing.

Unless otherwise defined, all terms (including technical terms and scientific terms) used in the specification have the same meaning as commonly understood by one skilled in the art to which the present disclosure belongs. Furthermore, terms such as terms defined in the dictionaries commonly used should be interpreted as having a meaning consistent with the meaning in the context of the related technology and should not be interpreted in ideal or overly formal meanings unless explicitly defined herein.

It will be understood that the terms "include", "comprise", "have", and the like specify the presence of features, numbers, steps, operations, elements, or components, described in the specification, or a combination thereof, not precluding the presence or additional possibility of one or more other features, numbers, steps, operations, elements, or components or a combination thereof.

Hereinafter, in the specification, "viewed on a plane" is defined as a state in which the subject element(s) is viewed from a third direction DR3. Furthermore, "overlap" refers to a state in which components overlap each other when viewed on a plane.

Hereinafter, embodiments of the present disclosure will be described with reference to accompanying drawings.

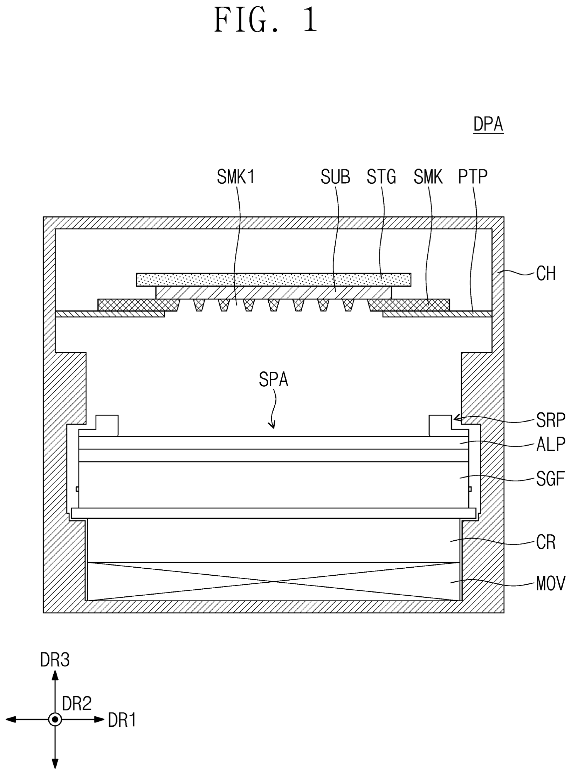

FIG. 1 is a schematic view of a spray device SPA and a deposition device DPA according to an embodiment of the present disclosure.

By way of example, FIG. 1 illustrates a schematic structure in an interior of the deposition device DPA and a front structure of the spray device SPA when viewed from a second direction DR2.

Referring to FIG. 1, the deposition device DPA, according to an embodiment of the present disclosure, includes a chamber CH, a substrate stage STG, a mask SMK, a barrier plate PTP, a spray device SPA, and a movement unit MOV.

The chamber CH may be defined as a vacuum chamber CH. During a deposition process, an interior of the chamber CH may be sealed. The substrate stage STG, the mask SMK, the barrier plate PTP, the spray device SPA, and the movement unit MOV may be disposed in the interior of the chamber CH.

The substrate stage STG fixes a substrate SUB. An electrostatic chuck may be disposed under the substrate stage STG. An electrode may be disposed in the electrostatic chuck, and a current may be applied to the electrode to generate electrostatic power or electrostatic force. Thus, the electrostatic chuck may attach or suction the substrate SUB. In another embodiment, the substrate stage STG may have vacuum suction holes for suctioning (e.g., adsorbing) and fixing the substrate SUB. In some embodiments, a support part DRB for supporting opposite sides of the substrate SUB may be used with the substrate stage STG.

The mask SMK is disposed under the substrate stage STG. The mask SMK guides a deposition position of the deposition material on the substrate SUB so that the deposition material may be deposited at a design position (e.g., a designed or intended position) on the substrate SUB. A plurality of cells SMK1 may be formed in the mask SMK. The plurality of cells SMK1 may pass (or extend) through the mask SMK along the third direction DR3. Furthermore, a plurality of holes formed in a fine size may be formed in each of the cells SMK1. The mask SMK may include a metal material, such as tungsten, molybdenum, or aluminium, or a ceramic material, such as aluminium oxide, but the present disclosure is not limited thereto.

The barrier plate PTP is disposed under the mask SMK. The barrier plate PTP may prevent the deposition material from scattering in directions other than the directions of the mask SMK and the substrate SUB.

The movement unit MOV may be disposed under the spray device SPA in the chamber CH, and the spray device SPA may be connected to an upper portion of the movement unit MOV. The movement unit MOV may move the spray device SPA along the second direction DR2. The spray device SPA may be move in the second direction DR2, and a nozzle NZ may spray the deposition material in the direction of (e.g., toward) the substrate SUB. The movement unit MOV, according to an embodiment of the present disclosure, may be implemented by various driving devices that may linearly reciprocate the spray device SPA.

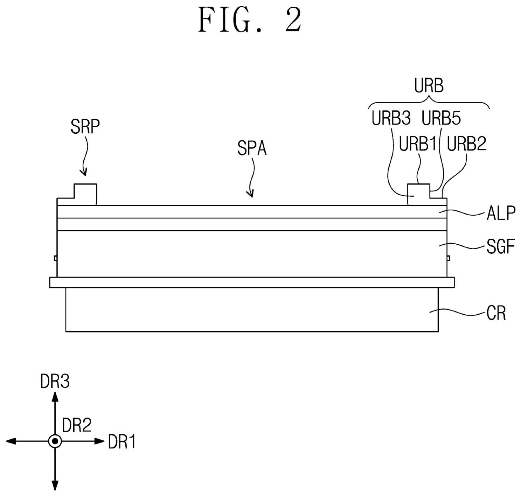

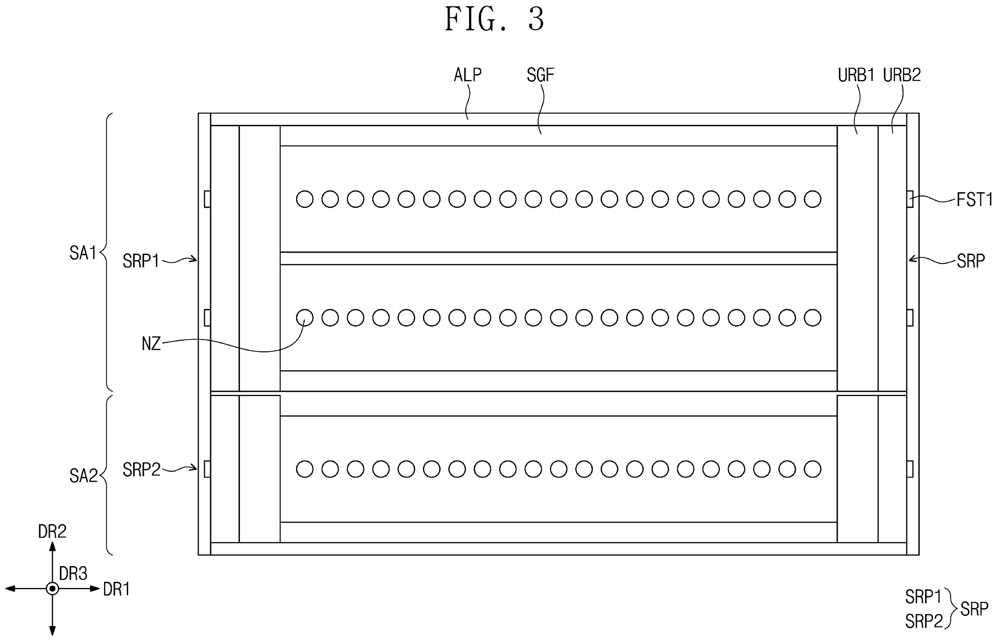

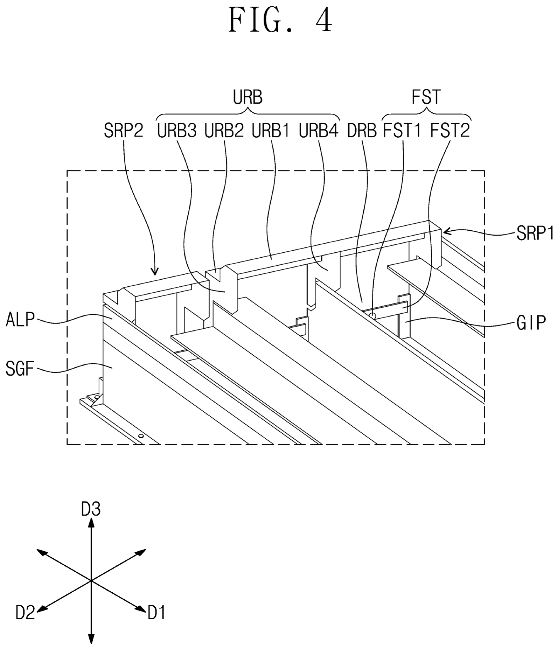

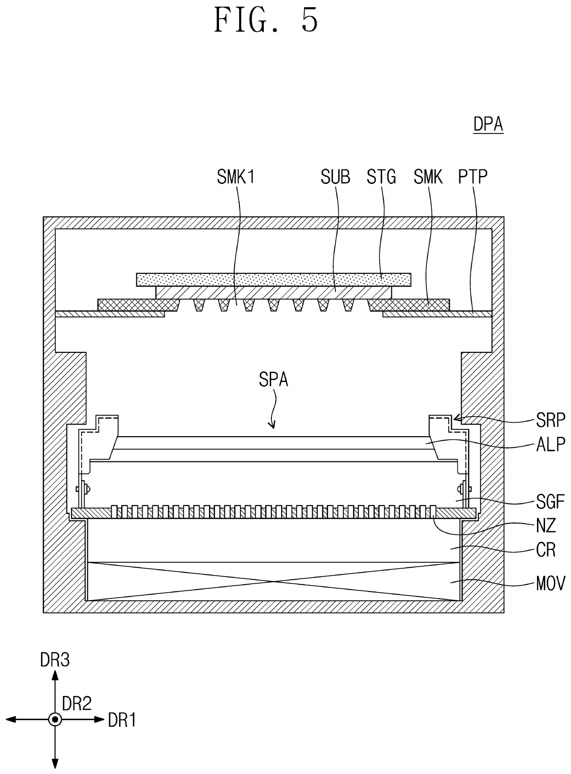

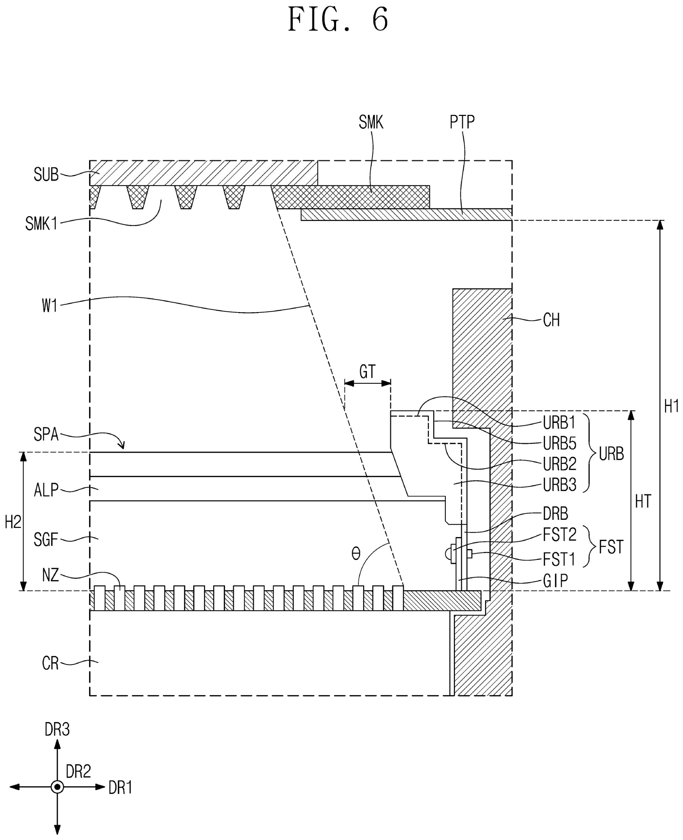

FIG. 2 is a front view of the spray device SPA according to an embodiment of the present disclosure. FIG. 3 is a plan view of the spray device SPA according to an embodiment of the present disclosure. FIG. 4 is a partial perspective view of the spray device SPA according to an embodiment of the present disclosure. FIG. 5 is a view of the spray device SPA illustrated in FIG. 1 from which a front side device frame SGF is removed but showing the recovery unit SRP. FIG. 6 is an enlarged view of the spray device SPA and the recovery unit SRP shown in FIG. 5.

Referring to FIGS. 2 to 6, the spray device SPA, according to an embodiment of the present disclosure, is disposed under the barrier plate PTP. The spray device SPA sprays the deposition material in the direction of (e.g., toward) the substrate SUB.

The spray device SPA includes a crucible CR, a device frame SGF, a nozzle NZ, a spray guide plate ALP, and a recovery unit SRP.

The crucible CR may have a container shape in which the deposition material is accommodated. A heating wire for heating the deposition material may be disposed in an interior of the crucible CR, but the present disclosure is not limited thereto. In addition, the crucible CR may include components for heating the deposition material.

The deposition material may be heated and vaporized in a crucible CR, and the vaporized deposition material may be sprayed in the direction of (e.g., toward) the substrate SUB through the nozzle NZ.

The device frame SGF may be disposed on the upper portion of the crucible CR. The nozzle NZ, a spray guide plate ALP, and a recovery unit SRP may be disposed in the device frame SGF.

The nozzle NZ may be disposed in the bottom part of the device frame SGF. A lower portion of the nozzle NZ may be connected to the crucible CR. The deposition material that is vaporized from the crucible CR may be supplied to the nozzle NZ. A plurality of nozzles NZ may be provided, and the plurality of nozzles NZ may be disposed in a row along a first direction DR1. The nozzle NZ may be disposed to face the mask SMK and the substrate SUB. The deposition material may be sprayed toward the mask SMK and the substrate SUB through the nozzle NZ.

Referring to FIG. 4, the spray guide plate ALP may be connected to an upper part of the device frame SGF and may guide a spray direction of the deposition material. The spray guide plate ALP may extend along the first direction DR1. In an embodiment of the present disclosure, the spray guide plate ALP may have a quadrangular plate shape, but the present disclosure is not limited thereto.

The spray guide plate ALP may limit the spray angle of the deposition material sprayed from the nozzle NZ. For example, when the deposition material is sprayed from the nozzle NZ toward the substrate SUB and mask SMK directions along the third direction DR3, the spray guide plate ALP may restrain or prevent the deposition material from being dispersed to scatter in the second direction DR2.

Referring to FIG. 6, the recovery unit SRP may be disposed in the device frame SGF and may recover the deposition material that scatters in directions other than the direction of the substrate SUB.

The recovery unit SRP may be disposed at a side portion of the device frame SGF. When the deposition material is sprayed from the nozzle NZ toward the substrate SUB and the mask SMK along the third direction DR3, the recovery unit SRP may recover the deposition material that scatters from the nozzle NZ in the first direction DR1, that is, the deposition material that scatters from the nozzle NZ toward a lateral side of the device frame SGF.

The recovery unit SRP may include a support part DRB, a fastening part FST, and a recovery part URB.

The support part DRB may be coupled to the device frame SGF and may extend in the third direction DR3. Referring to FIG. 4, in an embodiment of the present disclosure, the support part DRB may have a quadrangular plate shape, but the present disclosure is not limited thereto.

The fastening part FST may fix the support part DRB to the device frame SGF. The fastening part FST may include a fastening piece FST1 and a fastening bar FST2. A pair of fastening plates GIP that protrude in the second direction DR2 may be disposed at a side portion of the device frame SGF.

In an embodiment of the present disclosure, the fastening bar FST2 may have an elongated bar shape. The fastening bar FST2 may be disposed in the second direction DR2. Opposite ends of the fastening bar FST2 may be disposed to span (e.g., to extend between) the pair of fastening plates GIP.

The fastening piece FST1 may fasten the fastening bar FST2 to the support part DRB. In an embodiment of the present disclosure, the fastening piece FST1 may include components that may fasten the fastening bar FST2 to the support part DRB. As an example, the fastening piece FST1 may include a bolt, a nut, a screw, a rivet, and the like.

Because the fastening piece FST1 couples the fastening bar FST2 to the support part DRB, opposite ends of the fastening bar FST2 may be closely attached to the pair of fastening plates GIP, and the support part DRB may be fixed to a side portion of the device frame SGF.

The recovery part URB may be connected to an upper portion of the support part DRB and may recover the deposition material that scatters toward a lateral side of the device frame SGF.

Referring to FIGS. 5 and 6, the recovery part URB may protrude in the direction of the nozzle NZ.

The recovery part URB may include a plurality of pockets. The plurality of pockets may be disposed with a height difference with respect to each other along the third direction DR3.

In an embodiment of the present disclosure, the recovery part URB may include a lower pocket URB2, a stepped part URB5, an upper pocket URB1, and a pair of side walls URB3.

The lower pocket URB2 may be connected to an upper portion of the support part DRB and may be disposed in parallel in the first direction DR1. In an embodiment of the present disclosure, the lower pocket URB2 may have a quadrangular plate shape, but the present disclosure is not limited thereto.

The stepped part URB5 may be connected to an end of the lower pocket URB2 and may be disposed in parallel to the third direction DR3. In the embodiment of the present disclosure, the stepped part URB5 may have a quadrangular plate shape, but the present disclosure is not limited thereto.

The upper pocket URB1 may be connected to an end of the stepped part URB5 and may be disposed in parallel to the first direction DR1. In an embodiment of the present disclosure, the upper pocket URB1 may have a quadrangular plate shape, but the present disclosure is not limited thereto.

According to the above-described structure, the lower pocket URB2, the stepped part URB5, and the upper pocket URB1 may define a step shape.

The pair of side walls URB3 may be connected to opposite side portions of each of the lower pocket URB2, the stepped part URB5, and the upper pocket URB1.

Referring to FIG. 3, the device frame SGF may include a plurality of spray areas. The plurality of spray areas may be divided and arranged along the second direction DR2. Furthermore, a nozzle NZ may be disposed in each of the plurality of spray areas.

In an embodiment of the present disclosure, the plurality of spray areas may include a first spray area SA1 and a second spray area SA2.

The first spray area SA1 may be defined as a spray area in which a deposition material having the same substance from among the plurality of spray areas is sprayed.

The second spray area SA2 may be defined as a spray area in which a deposition material having a substance that is different from that of the first spray area SA1 from among the plurality of spray areas is sprayed.

The recovery unit SRP may be disposed to be separated from each other in the first spray area SA1 and the second spray area SA2. In an embodiment of the present disclosure, a first recovery unit SRP1 may be disposed in the first spray area SA1, and a second recovery unit SRP2 may be disposed in the second spray area SA2.

Referring to FIG. 4, the first recovery unit SRP1 may further include an intermediate plate URB4. The intermediate plate URB4 may be disposed between a pair of side walls URB3. The intermediate plate URB4 may be disposed between a plurality of spray areas in the first spray area SA1. The intermediate plate URB4 may protrude toward a central portion of the device frame SGF.

In such an embodiment, the pair of side walls URB3 may be disposed at peripheries of the first spray area SA1. The pair of side walls URB3 may protrude from the periphery of the first spray area SA1 toward a central portion of the device frame SGF.

The deposition material that scatters from the spray areas included in the first spray area SA1 may be collected in the upper pocket URB1, the stepped part URB5, and the lower pocket URB2 of the first recovery unit SRP1 with the intermediate plate URB4 interposed therebetween.

Similarly, the deposition materials that scatters from the spray areas included in the second spray area SA2 may be collected in the upper pocket URB1 and the stepped part URB5, and the lower pocket URB2 of the second recovery unit SRP2.

When the deposition materials having different substances are sprayed from the plurality of spray areas, the recovery units SRP separated from each other may be disposed in the plurality of spray areas, respectively, so that the different substances are collected separately.

Referring to FIG. 6, an imaginary line connecting an end point of the nozzle NZ and an end point of the substrate SUB with respect to the first direction DR1 may be defined as a reference line W1. The reference line W1 may form an inclination or angle θ with the nozzle NZ. The inclination or angle θ may define a spray angle at which the deposition material sprayed from the end point of the nozzle reaches the end point of the substrate.

As an example, the angle θ of the reference line W1 may be about 78°, but the present disclosure is not limited thereto.

In such an embodiment, an interval between the end point of the recovery unit SRP and the reference line W1 may be defined as a recovery interval GT. In more detail, an interval between the end point of the upper pocket URB1 and the reference line W1 may be defined as the recovery interval GT.

Furthermore, a height between the bottom portion of the device frame SGF and the barrier plate PTP may be defined as a reference height H1.

In such an embodiment, the height of the recovery unit SRP may be defined as a recovery height HT.

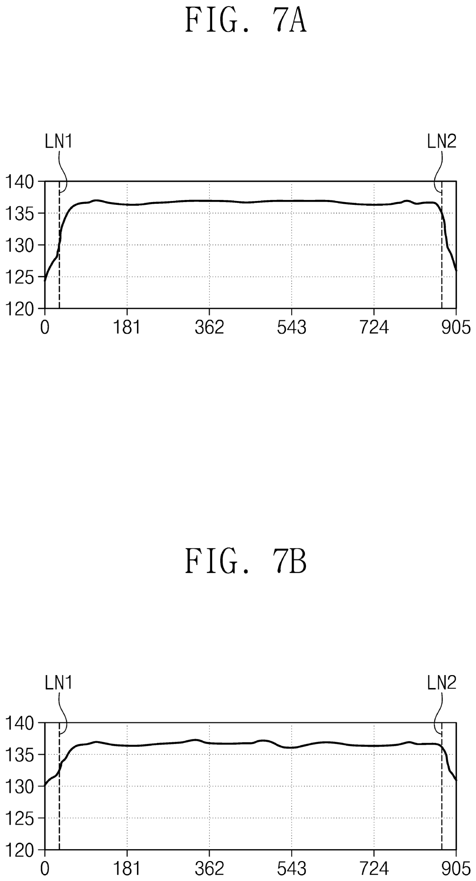

Hereinafter, appropriate ranges of the recovery interval GT and the recovery height HT, according to embodiments of the present disclosure, will be derived with reference to the experimental results disclosed in Tables 1 to 4 and FIGS. 7A to 7G.

**Table 1**

| Recovery interval (mm) | Range of a deposition material deposited at a central portion of a substrate (Å) | Film thickness range of a deposition material deposited at a peripheral portion of a substrate (Å) |
|---|---|---|
| 0 | 131 ~ 138 | 124 ~ 131 |
| 10 | 133 ~ 138 | 130 ~ 133 |
| 20 | 136 ~ 138 | 134 ~ 136 |
| 30 | 136 ~ 138 | 134 ~ 136 |
| 40 | 136 ~ 138 | 134 ~ 136 |
| 50 | 136 ~ 138 | 134 ~ 136 |
| 60 | 136 ~ 138 | 134 ~ 136 |

### Purpose of experiments

Measurement of a film thickness of a deposition material deposited at a central portion of a substrate and a peripheral portion of the substrate for respective recovery intervals.

### Experimental conditions

Recovery height HT: 230 mm
Angle of a reference line W1: 78°
Range of a peripheral portion of a substrate SUB: 0 mm to 50 mm and 855 to 905 mm
Range of a central portion of a substrate SUB: 50 mm to 855 mm

Table 1 describes a film thickness range of the deposition material deposited at the central portion of the substrate SUB and a film thickness range of the deposition material deposited at the peripheral portion of the substrate SUB according to the recovery interval GT. The purpose of the experiments is to measure the film thicknesses of the deposition materials at the central portion of the substrate SUB and the peripheral portion of the substrate SUB according to the recovery interval GT.

In the experiment, the unit of the recovery interval GT is mm, and the unit of the film thickness range is Å, that is, 10⁻¹⁰ m.

As the experimental conditions, the recovery height HT was set to 230 mm. Furthermore, the angle of the reference line W1 was set to 78°.

Furthermore, a range of the peripheral portion of the substrate SUB was set to 0 mm to 50 mm and 855 mm to 905 mm. A range of the central portion of the substrate SUB was set to 50 mm to 855 mm.

In the experimental condition, a cell SMK1 of the mask SMK was not applied.

Generally, a plurality of cells SMK1 are formed in the mask SMK to deposit the deposition material in a position designed on the substrate SUB.

The purpose of the experiment is to measure the film thickness range of the deposition material deposited at the central portion of the substrate SUB and the film thickness range of the deposition material deposited at the peripheral portion of the substrate SUB according to the recovery interval GT. Accordingly, to derive the experimental results, a plurality of cells SMK1 are not formed in the mask SMK, and a central portion of the mask SMK is open. Accordingly, under the experimental condition, the central portion and peripheral portion of the substrate SUB are exposed to the spray device SPA through a central portion of the mask SMK.

The experimental data shown in FIG. 7A illustrates the film thickness of the deposition material according to the lengthwise direction DR1 of the substrate SUB when the recovery interval GT is 0 mm.

Referring to FIG. 7A, the graph line of the experimental data represents the film thickness of the deposition material deposited on the substrate, and LN1 and LN2 represent lines that distinguish the peripheral portion of the substrate SUB and the central portion of the substrate SUB.

When the recovery interval GT is 0 mm, that is, when the upper pocket URB1 of the recovery unit SRP contacts the reference line W1, the film thickness range of the deposition material deposited at the central portion of the substrate SUB was around 131 Å to around 138 Å. Furthermore, the film thickness range of the deposition material deposited at the peripheral portion of the substrate SUB was around 124 Å to around 131 Å.

For analysis, when the recovery unit SRP contacts the reference line W1, it may be predicted that a spray path of the deposition material sprayed from the nozzle NZ is obstructed by the upper pocket URB1 of the recovery unit SRP. Accordingly, the peripheral portion of the substrate SUB may not be smoothly deposited. As a result, the peripheral portion of the substrate SUB has been deposited significantly thin compared to the central portion of the substrate SUB.

It may be identified through the experimental data disclosed in FIG. 7A that the formation of the recovery unit SRP to contact the reference line W1 affects a deposition quality on the substrate SUB.

The experimental data shown in FIG. 7B illustrates the film thickness of the deposition material according to the lengthwise direction DR1 of the substrate SUB when the recovery interval GT is 10 mm.

Referring to FIG. 7B, the graph line of the experimental data represents the film thickness of the deposition material deposited on the substrate, and LN1 and LN2 represent lines that distinguish the peripheral portion of the substrate SUB and the central portion of the substrate SUB.

When the recovery interval GT is 10 mm, that is, when the reference line W1 and the upper pocket URB1 of the recovery unit SRP has an interval of 10 mm, the film thickness range of the deposition material deposited at the central portion of the substrate SUB was around 133 Å to around 138 Å. Furthermore, the film thickness range of the deposition material deposited at the peripheral portion of the substrate SUB was around 130 Å to around 133 Å.

For analysis, when the recovery unit SRP is spaced apart from the reference line W1 by 10 mm, a spray path of the deposition material sprayed from the nozzle NZ is slightly obstructed by the upper pocket URB1 of the recovery unit SRP. Accordingly, the deposition was affected at the peripheral portion of the substrate SUB. As a result, the peripheral portion of the substrate SUB has been deposited slightly thin compared to the central portion of the substrate SUB.

It may be identified through the experimental data shown in FIG. 7B that the deposition quality on the substrate SUB is affected even when the recovery unit SRP is spaced apart from the reference line W1 by around 10 mm.

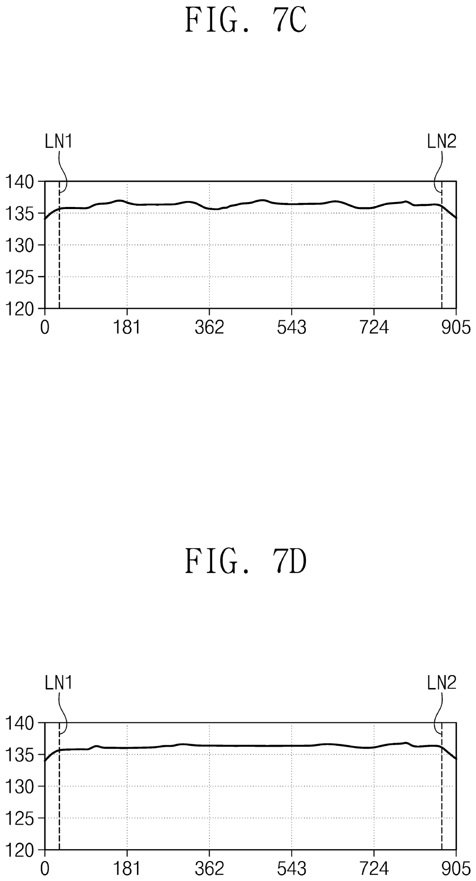

The experimental data shown in FIG. 7C illustrates the film thickness of the deposition material according to the lengthwise direction DR1 of the substrate SUB when the recovery interval GT is 20 mm.

Referring to FIG. 7C, the graph line on the experimental data represents the film thickness of the deposition material deposited on the substrate, and LN1 and LN2 represent lines that distinguish the peripheral portion of the substrate SUB and the central portion of the substrate SUB.

When the recovery interval GT is 20 mm, that is, when the reference line W1 and the upper pocket URB1 of the recovery unit SRP has an interval of 20 mm, the film thickness range of the deposition material deposited at the central portion of the substrate SUB was around 136 Å to around 138 Å. Furthermore, the film thickness range of the deposition material deposited at the peripheral portion of the substrate SUB was around 134 Å to around 136 Å.

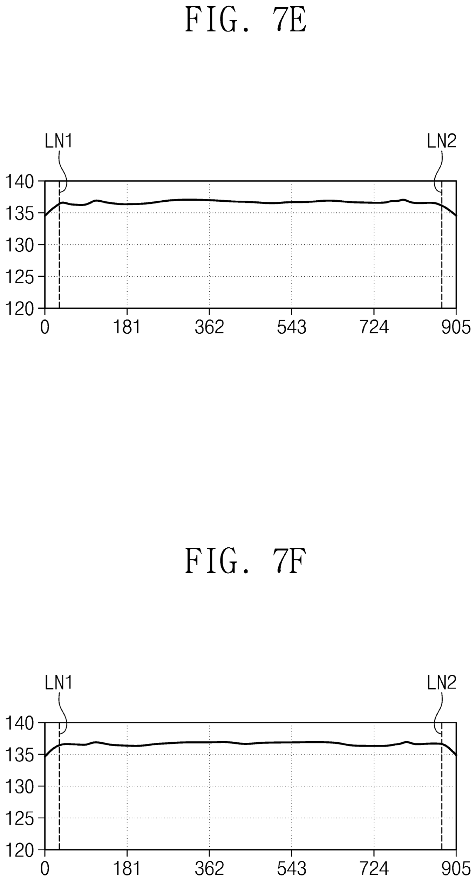

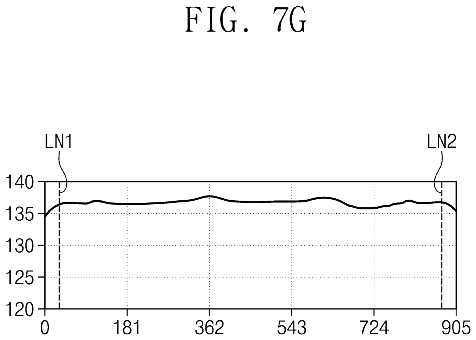

Furthermore, the experimental data shown in in FIG. 7D illustrates the film thickness of the deposition material according to the lengthwise direction DR1 of the substrate SUB when the recovery interval GT is 30 mm. The experimental data shown in FIG. 7E illustrates the film thickness of the deposition material according to the lengthwise direction DR1 of the substrate SUB when the recovery interval GT is 40 mm. The experimental data shown in FIG. 7F illustrates the film thickness of the deposition material according to the lengthwise direction DR1 of the substrate SUB when the recovery interval GT is 50 mm. The experimental data shown in FIG. 7G illustrates the film thickness of the deposition material according to the lengthwise direction DR1 of the substrate SUB when the recovery interval GT is 60 mm.

When the recovery interval GT is 20 mm or more, that is, when the reference line W1 and the upper pocket URB1 of the recovery unit SRP has an interval of 20 mm or more, the film thickness range of the deposition material deposited at the central portion of the substrate SUB was around 136 Å to around 138 Å that correspond to the same range. Furthermore, the film thickness range of the deposition material deposited at the peripheral portion of the substrate SUB was around 134 Å to around 136 Å that correspond to the same range.

For analysis, when the recovery unit SRP is spaced apart from the reference line W1 by 20 mm or more, a spray path of the deposition material sprayed from the nozzle NZ is not obstructed by the upper pocket URB1 of the recovery unit SRP. Accordingly, the film thickness of the deposition material at the peripheral portion of the substrate SUB is not significantly decreased compared to the central portion of the substrate SUB.

It may be identified that the film thickness of the deposition material does not show a significant difference between the central portion of the substrate SUB and the peripheral portion of the substrate SUB and forms a relatively constant range value considering that the unit of the film thickness is Å.

In conclusion, the recovery unit SRP did not affect the film thickness range of the deposition material at the peripheral portion of the substrate SUB when the recovery interval GT was 20 mm or more. Accordingly, the recovery interval GT is appropriately designed to be about 20 mm or more.

**Table 2**

| Recovery interval (mm) | Spray amount (g) | Recovery amount (g) | Recovery rate (%) |
|---|---|---|---|
| 0 | 3720.1 | 219.5 | 5.9 |
| 10 | 3721.6 | 208.4 | 5.6 |
| 20 | 3714.3 | 182.0 | 4.9 |
| 30 | 3718.4 | 174.8 | 4.7 |
| 40 | 3712.9 | 167.1 | 4.5 |
| 50 | 3722.5 | 156.3 | 4.2 |
| 60 | 3716.4 | 144.9 | 3.9 |

### Purpose of experiments

Measuring a recovery rate of a deposition material by measuring a spray amount and a recovery amount for respective intervals.

### Experimental conditions

Reference height H1: 500 mm
Recovery height HT: 230 mm
Design target recovery rate: 4% or more

Table 2 describes the recovery rate derived based on measuring the spray amount and the recovery amount of the deposition material according to the recovery interval GT. The purpose of the experiment is to measure the recovery rate according to the recovery interval GT.

In the experiment, the unit of the recovery interval GT is mm, the unit of the spray amount and the recovery amount is g, and the unit of the recovery rate is %.

In the experimental condition, the reference height H1 was set to 500 mm. As described above, the reference height H1 may define a height between a bottom portion of the device frame SGF and the barrier plate PTP.

Furthermore, the recovery height HT was set to 230 mm. As described above, the recovery height HT may define the height of the recovery unit SRP.

In the experimental condition, the design target recovery rate was set to 4% or more. When the recovery rate is less than 4%, the recovery amount is small, and thus, the recovery costs outweigh any cost savings and may be inefficient. Accordingly, an appropriate level of the design target recovery rate may be 4% or more.

Referring to Table 2, when the recovery interval GT is 60 mm, the amount of deposition material sprayed from the nozzle NZ was 3716.4 g, and the amount of deposition material recovered from the recovery unit SRP was 144.9 g. Accordingly, the calculated recovery rate was 3.899%, and 3.9% was derived by rounding up from the second decimal place.

When the recovery interval GT was 60 mm, the recovery rate was derived as 3.9%, which was less than the design target recovery rate of 4%. Accordingly, when the recovery interval GT is 60 mm, insufficient deposition material may be recovered.

Next, when the recovery interval GT is 50 mm, the amount of deposition material sprayed from the nozzle NZ was 3722.5 g, and the amount of deposition material recovered from the recovery unit SRP was 156.3 g. Accordingly, the calculated recovery rate was 4.199%, and 4.2% was derived by rounding up from the second decimal place.

When the recovery interval GT was 50 mm, the recovery rate was derived as 4.2%, and the design target recovery rate of 4% was achieved.

Furthermore, referring to Table 2, even in experiments with a recovery interval GT of 0 mm to 40 mm, both the recovery rates calculated from the spray amount and recovery amount exceeded 4%.

In an analysis of the experimental results, the recovery amount and the recovery rate tend to increase as the recovery interval GT becomes smaller, that is, the recovery unit SRP approaches the reference line W1.

Accordingly, considering the design target recovery rate, the recovery interval GT may be designed to be about 50 mm or less.

In summary, it may be appropriate to design the recovery interval GT at consideration of a) the film thickness uniformity of the deposition material deposited in the central portion of the substrate SUB and the peripheral portion of substrate SUB and b) the design target recovery rate.

Accordingly, it may be appropriate to design the recovery interval in a range of about 20 mm to about 50 mm.

Furthermore, because the experimental results of the recovery rate were derived under the condition that the recovery height HT is 230 mm, it may be predicted that the recovery rate will be better when the recovery height HT is 250 mm under the condition that the recovery interval is in the range of about 20 mm to about 50 mm.

Accordingly, it may be appropriate to set the recovery height HT to about 230 mm or more.

Referring to FIG. 6, the recovery height HT of the recovery unit SRP may be designed to be higher than the height H2 of the spray guide plate ALP. When the height of the recovery unit SRP is designed to be the height of the spray guide plate ALP or more, the deposition material that scatters in a lateral direction of the device frame SGF may be effectively collected.

In an embodiment of the present disclosure, the recovery height HT of the recovery unit SRP compared to the height H2 of the spray guide plate ALP may be designed in the range of 1.013 to 1.022.

As an example, when the height H2 of the spray guide plate ALP is designed in the range of 225 mm to 227 mm, the recovery height HT of the recovery unit SRP may be 230 mm or more.

**Table 3**

| Recovery height (mm) | Detection amount of first deposition material (g) | Detection amount of second deposition material (g) | Inclusion rate (%) |
|---|---|---|---|
| 230 | 4.919 | 0.020 | 0.40 |
| 240 | 5.110 | 0.022 | 0.43 |
| 250 | 5.253 | 0.024 | 0.46 |
| 260 | 5.343 | 0.030 | 0.54 |
| 270 | 5.367 | 0.036 | 0.67 |
| 280 | 5.378 | 0.044 | 0.81 |
| 300 | 5.381 | 0.055 | 1.01 |
| 390 | 5.457 | 0.098 | 1.76 |

### Purpose of experiments

Measuring a detection amount of a first deposition material and a detection amount of a second deposition material for respective recovery heights to measure an inclusion rate in a recovery unit SRP when deposition materials having different substances are sprayed.

### Experimental conditions

Spray amount of the first deposition material: 100 g
Spray amount of the second deposition material: 100 g
Recovery interval GT: 20 mm

Inclusion rate of the design target: 0.5% or less 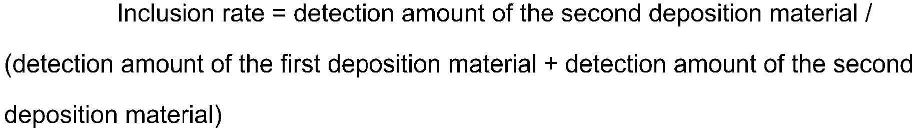 Inclusion rate = detection amount of the second deposition material / (detection amount of the first deposition material + detection amount of the second deposition material)

Table 3 illustrates the experimental results in which deposition materials having different substances are mixed into the recovery unit SRP when the deposition materials with the different substances are sprayed.

As an example, referring to FIG. 3, this experiment may correspond to situation in which the first deposition material is sprayed through a first spray area SA1 and the second deposition material is sprayed through a second spray area SA2.

Table 3 describes an inclusion rate of mixing in the recovery unit SRP, which is derived based on the detection rate of the first deposition material and the detection rate of the second deposition material according to the recovery height HT of the recovery unit SRP. The purpose of the experiment is to measure an inclusion rate according to the recovery height HT when the deposition materials having different substances are sprayed.

In the experiment, the unit of recovery height HT is mm, the unit of the detection amount of the first deposition material and the detection amount of the second deposition material is g, and the inclusion rate is %.

In the experimental condition, the spray amount of the first deposition material is 100 g, and the spray amount of the second deposition material is 100 g. Furthermore, the recovery interval GT was set to 20 mm.

In the experimental condition, the design target inclusion rate was set to 0.5% or less. When the inclusion rate exceeds 0.5%, the costs required to separate the first deposition material and the second deposition material may be more consumed, which may be inefficient. Accordingly, an appropriate level of the design target inclusion rate may be about 0.5% or less.

Referring to Table 3, when the recovery height HT of the recovery unit SRP was 260 mm, the detection amount of the first deposition material was 5.343 g and the detection amount of the second deposition material was 0.030 g. Accordingly, the inclusion rate was measured as 0.538%. Rounding to the second decimal place, the inclusion rate is 0.54%. In other words, when the recovery height HT was 260 mm, the inclusion rate was 0.54%, exceeding the design target inclusion rate of 0.5%.

Accordingly, when the recovery interval is 20 mm, the recovery height HT of the recovery unit SRP being 260 mm is inappropriate.

Furthermore, even when the recovery height HT was 270 mm to 390 mm, the entire inclusion rate exceeded 0.5% similarly. Furthermore, the inclusion rate tends to increase as the recovery height HT increases. It may be predicted that the inclusion rate increases because the first deposition material and the second deposition material sprayed from the nozzle NZ spread in all directions while the scattering distances thereof increase.

Next, when the recovery height HT was 250 mm, the detection amount of the first deposition material was 5.253 g and the detection amount of the second deposition material was 0.024 g. Accordingly, the inclusion rate was measured as 0.455%. Rounding to the second decimal place, the inclusion rate is 0.46%. In other words, when the recovery height HT was 250 mm, the inclusion rate was 0.46%, not exceeding the design target inclusion rate of 0.5%.

Furthermore, even when the recovery height HT was 230 mm and 240 mm, the entire inclusion rate similarly did not exceed 0.5%. For example, as the recovery height HT decreases, the inclusion rate tends to decrease. It may be predicted that the inclusion rate is lowered because the first deposition material and the second deposition material sprayed from the nozzle NZ are recovered by the recovery unit SRP before scattering over a wide range.

Based on the results disclosed in Table 3, when the deposition materials having different substances are sprayed when the recovery interval GT is 20 mm, the recovery height HT of the recovery unit SRP may be about 250 mm or less in relation to the design target inclusion rate.

**Table 4**

| Recovery height (mm) | Detection amount of first deposition material (g) | Detection amount of second deposition material (g) | Inclusion rate (%) |
|---|---|---|---|
| 230 | 4.187 | 0.018 | 0.43 |
| 240 | 4.220 | 0.019 | 0.45 |
| 250 | 4.428 | 0.022 | 0.49 |
| 260 | 4.503 | 0.026 | 0.57 |
| 270 | 4.592 | 0.033 | 0.71 |
| 280 | 4.890 | 0.042 | 0.85 |
| 300 | 4.977 | 0.052 | 1.03 |
| 390 | 5.052 | 0.093 | 1.81 |

### Purpose of experiments

Measuring a detection amount of a first deposition material and a detection amount of a second deposition material for respective recovery heights to measure an inclusion rate in a recovery unit SRP when deposition materials having different substances are sprayed.

### Experimental conditions>

Spray amount of the first deposition material: 100 g
Spray amount of the second deposition material: 100 g
Recovery interval GT: 50 mm

Inclusion rate of the design target: 0.5% or less 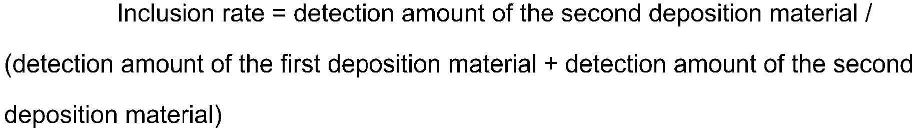 Inclusion rate = detection amount of the second deposition material / (detection amount of the first deposition material + detection amount of the second deposition material)

Similar to Table 3, Table 4 illustrates the experimental results in which deposition materials having different substances are mixed into the recovery unit SRP when the deposition materials with the different substances are sprayed.

In the experimental condition, the spray amount of the first deposition material is 100 g, and the spray amount of the second deposition material is 100 g. Furthermore, the recovery interval GT was set to 50 mm.

Similarly, in the experimental condition, the design target inclusion rate was set to 0.5% or less.

Referring to Table 4, when the recovery height HT of the recovery unit SRP was 260 mm, the detection amount of the first deposition material was 4.503 g and the detection amount of the second deposition material was 0.026 g. Accordingly, the inclusion rate was measured as 0.574%. Rounding to the second decimal place, the inclusion rate is 0.57%. In other words, when the recovery height HT was 260 mm, the inclusion rate was 0.57%, exceeding the design target inclusion rate of 0.5%.

Accordingly, when the recovery interval GT is 50 mm, the recovery height HT of the recovery unit SRP being 260 mm is inappropriate.

Furthermore, even when the recovery height HT was 270 mm to 390 mm, the entire inclusion rate exceeded 0.5% similarly.

As a result of the experiment, by changing the recovery interval GT from 20 mm to 50 mm, the detection amount of the first deposition material and the detection amount of the second deposition material decreased as the recovery interval GT increased. It may be predicted that the recovery amount decreases due to the increased distance between the recovery unit SRP and the reference line W1.

Next, when the recovery height HT was 250 mm, the detection amount of the first deposition material was 4.428 g and the detection amount of the second deposition material was 0.022 g. Accordingly, the inclusion rate was measured as 0.494%. Rounding to the second decimal place, the inclusion rate is 0.49%. In other words, when the recovery height HT was 250 mm, the inclusion rate was 0.49%, not exceeding the design target inclusion rate of 0.5%.

Furthermore, even when the recovery height HT was 230 mm and 240 mm, the entire inclusion rate similarly did not exceed 0.5%. For example, as the recovery height HT decreases, the inclusion rate tends to decrease. It may be predicted that the inclusion rate is lowered because the first deposition material and the second deposition material sprayed from the nozzle NZ are recovered by the recovery unit SRP before scattering sufficiently.

Based on the results disclosed in Table 4, when the deposition materials having different substances are sprayed when the recovery interval is 50 mm, the recovery height HT of the recovery unit SRP may be about 250 mm or less in relation to the design target inclusion rate.

Based on the experimental results disclosed in Tables 1 to 4, an appropriate design range of the recovery unit SRP may be derived as follows.

It is desirable to design the recovery interval GT and the recovery height HT by comprehensively considering a) the film thickness uniformity of the deposition material deposited at the central portion of the substrate SUB and the peripheral portion of substrate SUB, b) the design target recovery rate, and c) the inclusion rate, at which repurification is possible.

Accordingly, it may be appropriate to design the appropriate recovery interval GT of the recovery unit SRP within the range of 20 mm to 50 mm from the reference line W1 based on the experimental results of Table 1 and Table 2 above.

The appropriate recovery height HT of the recovery unit SRP may be derived based on the appropriate recovery interval GT.

The recovery height HT of the recovery unit SRP may be appropriate to be designed in the range of 230 mm to 250 mm based on the experimental results of Tables 2 to 4 above a) when deposition materials having different substances are sprayed from a plurality of spray areas of the device frame SGF. In this case, the recovery height HT may be designed in a range of around 46% to 50% with respect to the reference height H1.

It may be appropriate to design the recovery height within the range of 230 mm to 500 mm b) when the deposition material with the same substance is sprayed from the plurality of spray areas of the device frame SGF. In other words, it may be designed to be 230 mm or more and 500 mm or less, which is the height of the barrier plate PTP. When the deposition material having the same substance is sprayed, there is no problem of mixing, and thus, the recovery height may be extended to the height of the barrier plate PTP to increase the recovery rate.

In this case, the recovery height HT may be designed in a range of around 46% to 100% with respect to the reference height H1.

The spray device SPA and the deposition device DPA, according to an embodiment of the present disclosure, may recover and collect deposition materials that scatter in directions other than the direction of the substrate SUB through the above-described configuration and numerical range. Furthermore, waste of deposition material may be reduced or prevented, and the deposition material may be repurified and reused. Ultimately, the costs of the deposition process may be reduced, and the efficiency of the deposition process may be improved.

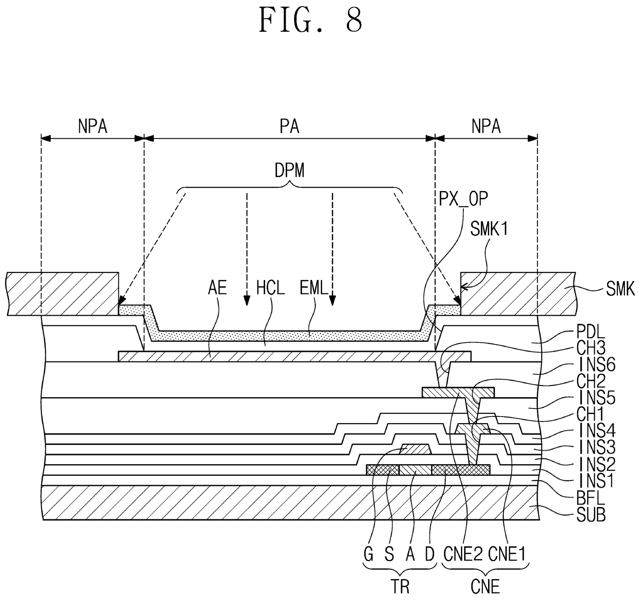

FIG. 8 is a view illustrating a state in which a deposition material DPM is provided onto a substrate SUB by a deposition device DPA illustrated in FIG. 1.

Referring to FIG. 8, a mask SMK may be disposed on a substrate SUB. The substrate SUB may be the same as or similar to the substrate SUB illustrated in FIG. 1. For convenience of description, an emission layer EML is illustrated as facing a top and the mask SMK is disposed on the emission layer EML, but, as illustrated in FIG. 1, they may be in an inverted state during a deposition process. For example, the emission layer EML may face a bottom, and the mask SMK may be disposed under the emission layer EML.

A hole control layer HCL may be disposed on a first electrode AE, and the mask SMK may be used to form the emission layer EML on the hole control layer HCL. A deposition material DPM may be provided on the hole control layer HCL through a cell SMK1 formed in the mask SMK. The emission layer EML may be formed of the deposition material DPM. By way of example, one emission layer EML was formed on the substrate SUB, but, in some embodiments, a plurality of emission layers EML may be formed on the substrate SUB.

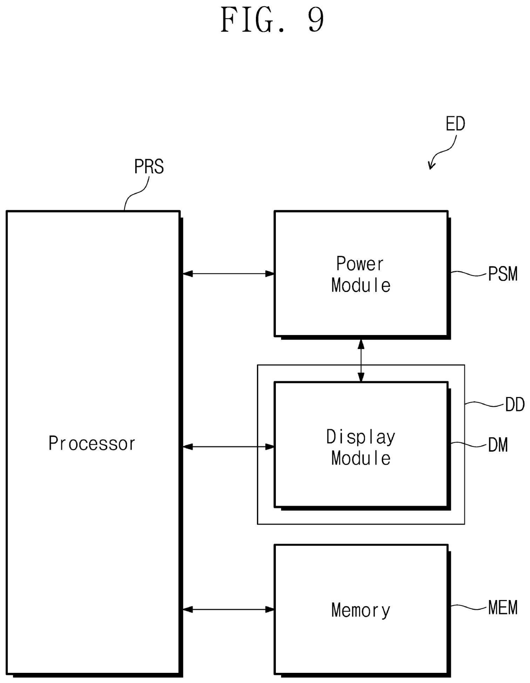

FIG. 9 is a block diagram describing an electronic device according to an embodiment of the present disclosure.

Referring to FIG. 9, an electronic device ED according to an embodiment includes a display device DD that provides a user with an image and may further include a module or a device having other additional functions in addition to the display device DD. The electronic device ED according to an embodiment may include a display module DM, a processor PRS, a memory MEM, and a power module PSM, and a display device DD may include a display module DM.

The processor PRS may include at least one of a central processing unit (CPU), an application processor (AP), a graphic processing unit (GPU), a communication processor (CP), an image signal processor (ISP), and a controller. The processor PRS may process an image signal to provide it to the display device DD, and the display device DD may generate an image corresponding to the image signal.

In an embodiment, the processor PRS may be divided into two or more parts from a functional or structural point of view to be provided. For example, the processor PRS may include a main processor in the form of a first driving chip including a central processing unit and an auxiliary processor in the form of a second driving chip including a controller that receives an image signal from the main processor and processes the image signal to meet interface specifications of the display module DM.

Data information that are necessary for an operation of the processor PRS or the display module DM may be stored in the memory MEM. When the processor PRS executes an application stored in the memory MEM, an image data signal and/or an input control signal may be transmitted to the display module DM, and the display module DM may process the provided signal and output image information through a display screen.

The power module PSM may include a power module, such as a power adapter or a battery device, and a power conversion module that converts electric power supplied by the power module to generate electric power for operation of the electronic device ED. The power module PSM may supply electric power to the display module DM and the processor PRS.

At least one of the components of the electronic device ED described above may be included in the display device DD according to the above-described embodiments. Furthermore, some of the individual modules that are functionally included in one module may be included in the display device DD and others may be provided separately from the display device DD. For example, the display device DD includes a display module DM, and the processor PRS, the memory MEM, and the power module PSM may be provided in the form of other devices in the electronic device ED rather than the display device DD.

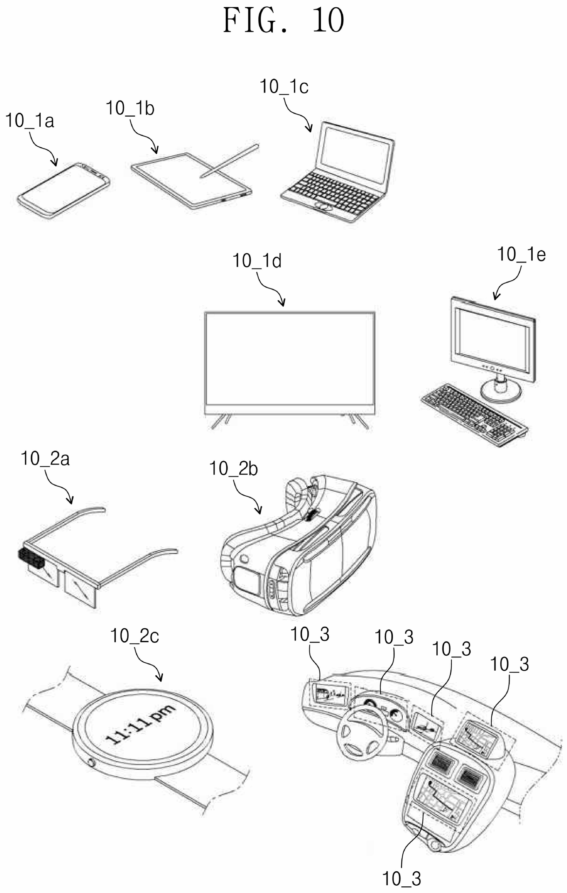

FIG. 10 illustrates schematic views of various electronic device according to various embodiments.

Referring to FIG. 10, the display device DD according to an embodiment of the present disclosure may be applied to various electronic devices. For example, various electronic devices, to which the display device DD according to an embodiment is applied, may include electronic devices for image display, such as a smartphone 10_1a, a tablet PC 10_1b, a laptop 10_1c, a TV 10_1d, or a desk monitor 10_1e.

Furthermore, various electronic devices to which the display device DD according to an embodiment is applied may include wearable electronic devices, such as smart glasses 10_2a, a head mounted display 10_2b, or a smart watch 10_2c. Furthermore, various electronic devices to which the display device DD according to an embodiment is applied may include electronic devices 10_3 for vehicles, such as an instrument panel for a vehicle, a center fascia, a center information display (CID) disposed on a dashboard, or a room mirror display.

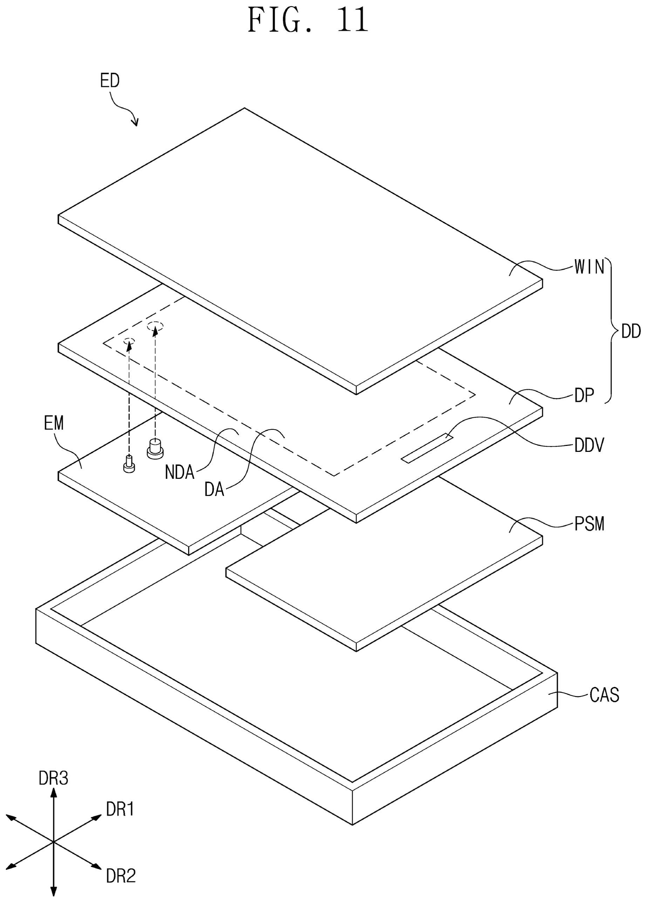

FIG. 11 is an exploded perspective view of an electronic device according to an embodiment of the present disclosure.

Referring to FIG. 11, the electronic device ED may include a display device DD, an electronic module EM, a power module PSM, and a case CAS. The display device DD may include a display module DM and a window WIN disposed on the display module DM.

The electronic module EM and the power module PSM may be disposed under the display device DD. The electronic module EM and the power module PSM may be connected to each other through a separate flexible circuit substrate.

The electronic module EM may control an operation of the display device DD. The electronic module EM may include the above-described processor PRS. The power module PSM may supply electric power to the electronic module EM and the display module DM.

The case CAS may be disposed under the electronic module EM and the power module PSM. The case CAS may accommodate the display device DD, the electronic module EM, and the power module PSM. The case CAS may protect the display device DD, the electronic module EM, and the power module PSM.

The display module DM may have short sides that extend in a first direction DR1 and long sides that extend in a second direction DR2. Corners of the display module DM may have a rounded shape.

The display module DM may have a display area DA and a non-display area NDA around the display area DA. The non-display area NDA may surround (e.g., may extend around a periphery of) the display area DA. The display area DA may generate an image, and the non-display area NDA may not generate an image.

The display module DM may include a display panel DP and a light conversion part that is disposed on the display panel DP. Similar to the display module DM, the display panel DP may have a display area DA and a non-display area NDA that is disposed around the display area DA to surround the display area DA. An image may be generated from the display area DA of the display panel DP.

According to an embodiment of the present disclosure, the display panel DP may include a light emitting display panel. For example, the display panel DP may be an organic light emitting display panel or an inorganic light emitting display panel. An emission layer of the organic light emitting display panel may include an organic light emitting material. An emission layer of the inorganic light emitting display panel may include quantum dots and quantum rods. Hereinafter, it will be described that the display panel DP is an organic light emitting display panel.

The light conversion part may receive the light generated by the display panel DP and may convert a color of the received light. Furthermore, the light conversion part may reduce a reflectance of external light. Such a configuration will be described in detail below.

The window WIN may have an optically transparent property. For example, the window WIM may include glass or a transparent plastic. The window WIN may protect the display module DM from external impacts and scratches. A front surface of the window WIN may correspond to the display surface of the display device DD described above.

The front surface of the window WIN may include a transmission area and a bezel area around the transmission area. The transmission area may transmit light. The bezel area may surround the transmission area and may be printed in a specific color to shield (or block) light. When viewed on a plane, the transmission area may overlap the display area DA, and the bezel area may overlap the non-display area NDA.

The image generated in the display area DA may be provided to an external user through the transmission area. The non-display area NDA may not be exposed to the outside due to the bezel area.

The display device DD may further include an input sensing part that is disposed between the display panel DP and the light conversion part. The input sensing part may include a plurality of sensing parts for sensing an external input. The sensing parts may sense external inputs in a capacitive manner.

The input sensing part may be directly manufactured (e.g., directly formed) on the display panel DP when the display panel DP is manufactured. However, the present disclosure is not limited thereto, and the input sensing part may be manufactured as a separate panel from the display panel DP and attached to the display panel DP by an adhesive.

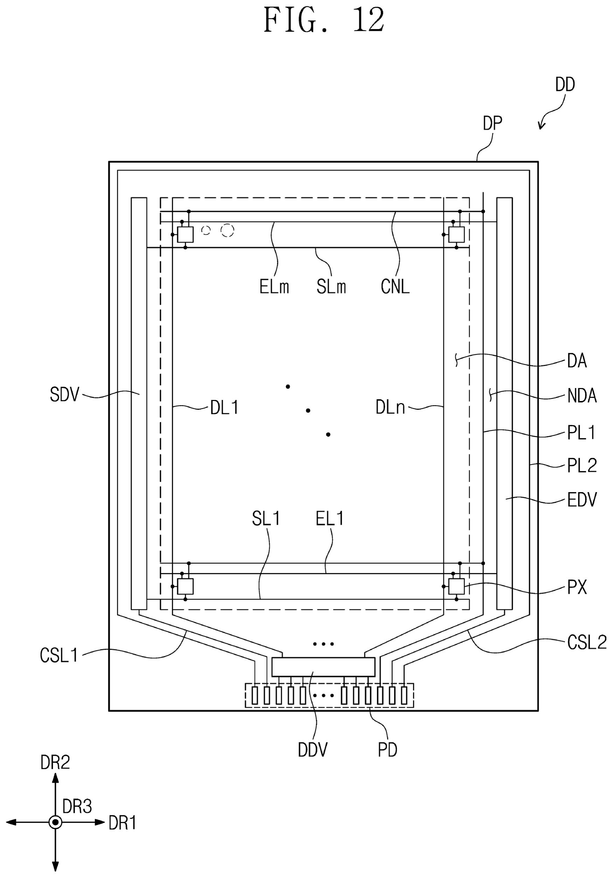

FIG. 12 is a plan view of the display panel illustrated in FIG. 11.

Referring to FIG. 12, the display device DD may include the display panel DP, a scan driver SDV, a data driver DDV, an emission driver EDV, and a plurality of pads PD.

The display panel DP may have a display area DA and a non-display area NDA that surrounds the display area DA. The display panel DP may include a plurality of pixels PX, a plurality of scan lines SL1 to SLm, a plurality of data lines DL1 to DLn, a plurality of emission lines EL1 to ELm, first and second control lines CSL1 and CSL2, first and second power supply lines PL1 and PL2, and connection lines CNL. Each of "m" and "n" is a natural number.

The pixels PX may be disposed in the display area DA. The scan driver SDV and the emission driver EDV may be disposed in the non-display area NDA that is adjacent to the long sides of the display panel DP, respectively. The data driver DDV may be arranged in the non-display area NDA adjacent to one of the short sides of the display panel DP. When viewed on a plane, the data driver DDV may be adjacent to a lower end of the display panel DP.

The scan lines SL1 to SLm may extend in the first direction DR1 to be connected to the pixels PX and the scan driver SDV. The data lines DL1 to DLn may extend in the second direction DR2 to be connected to the pixels PX and the data driver DDV. The emission lines EL1 to ELm may extend in the first direction DR1 to be connected to pixels PX and the emission driver EDV.

The first power line PL1 may extend in the second direction DR2 and may be disposed in the non-display area NDA. The first power line PL1 may be disposed between the display area DA and the emission driver EDV.

The connection lines CNL may extend in the first direction DR1 and may be arranged in the second direction DR2 to be connected to the first power line PL1 and the pixels PX. A first voltage may be applied to the pixels PX through the first power line PL1 and the connection lines CNL that are connected to each other.

The second power line PL2 may be disposed in the non-display area NDA and may extend along the long sides of the display panel DP and another short side of the display panel DP at where the data driver DDV is not disposed. The second power line PL2 may be disposed on an outside of the scan driver SDV and the emission driver EDV.

The second power line PL2 may extend toward the display area DA so as to be connected to the pixels PX. A second voltage having a level lower than a first voltage may be applied to the pixels PX through the second power line PL2.

The first control line CSL1 may be connected to the scan driver SDV and may extend toward a lower end of the display panel DP. The second control line CSL2 may be connected to the emission driver EDV and may extend toward a lower end of the display panel DP. The data driver DDV may be interposed between the first control line CSL1 and the second control line CSL2.

The pads PD may be positioned in the non-display area NDA adjacent to the bottom end of the display panel DP and may be closer to the bottom end of the display panel DP than the data driver DDV. The data driver DDV, the first and second power supply lines PL1 and PL2, the first and second control lines CSL1 and CSL2 may be connected to the pads PD. The data lines DL1 to DLn may be connected to the data drivers DDV, and the data drivers DDV may be connected to pads PD corresponding to the data lines DL1 to DLn.

The display device DD may further include a timing controller for controlling operations of the scan driver SDV, the data driver DDV, and the light emission driver EDV, and a voltage generator for generating first and second voltages. The timing controller and the voltage generator may be mounted on a printed circuit board and connected to the pads PD through the printed circuit board.

The scan driver SDV may generate a plurality of scan signals, and the scan signals may be applied to the pixels PX through the scan lines SL1 to SLm. The data driver DDV may generate a plurality of data voltages, and the data voltages may be applied to the pixels PX through the data lines DL1 to DLn. The emission driver EDV may generate a plurality of emission signals, and the emission signals may be applied to the pixels PX through the emission lines EL1 to ELm.

The pixels PX may receive the data voltages in response to the scan signals. The pixels PX may display an image by emitting light having a luminance corresponding to the data voltages in response to the emission signals.

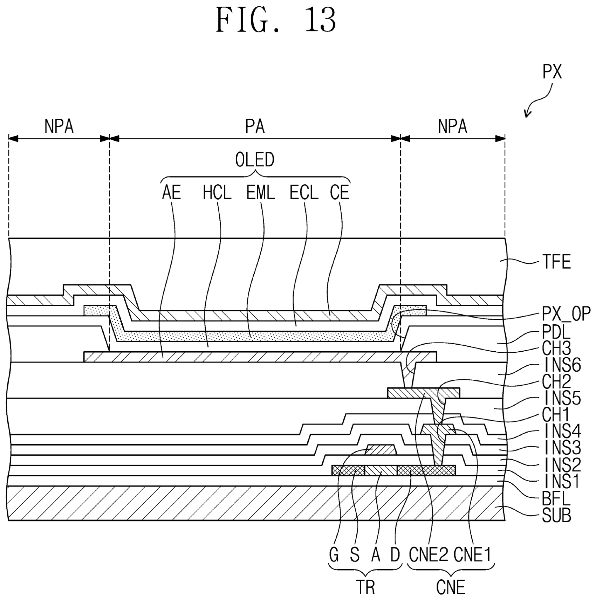

FIG. 13 is a view illustrating a cross section of any one pixel illustrated in FIG. 12 according to an embodiment.

Referring to FIG. 13, a pixel PX may include a transistor TR and a light emitting element OLED that is connected to the transistor TR. Although one pixel PX is illustrated, a plurality of pixels PX may be disposed on the substrate SUB.

The light emitting element OLED may include a first electrode AE, a second electrode CE, a hole control layer HCL, an electron control layer ECL, and an emission layer EML. The first electrode AE may be an anode electrode, and the second electrode CE may be a cathode electrode.

The transistor TR and the light emitting element OLED may be disposed on the substrate SUB. A planar area of the substrate SUB may be divided into an emission part PA and a non-emission part NPA around the emission part PA. The light emitting element OLED may be disposed on the emission part PA.

A buffer layer BFL may be disposed on the substrate SUB, and the buffer layer BFL may be an inorganic layer.

Semiconductor patterns "S", "A", and "D" may be disposed on the buffer layer BFL. The semiconductor patterns "S", "A", and "D" may include polysilicon. However, the present disclosure is not limited thereto, and the semiconductor patterns "S", "A", and "D" may include amorphous silicon or a metal oxide.

The semiconductor patterns "S", "A", and "D" may be doped with an N-type dopant or a P-type dopant. The semiconductor pattern may include a highly-doped area and a lightly-doped area. A conductivity of the highly-doped area may be greater than that of the lightly-doped area, and substantially, may act as a source electrode and a drain electrode of the transistor TR. The lightly-doped area may substantially correspond to an active (or a channel) of the transistor.

A source "S", an active "A", and a drain "D" of the transistor TR may be formed from the semiconductor patterns "S", "A", and "D". A first insulating layer INS1 may be disposed on the semiconductor patterns "S", "A", and "D". A gate electrode "G" of the transistor TR may be disposed on the first insulating layer INS1. A second insulating layer INS2 may be disposed on the gate electrode "G". A third insulating layer INS3 may be disposed on the second insulating layer INS2.

A connection electrode CNE may be disposed between the transistor TR and the light emitting element OLED to connect the transistor TR and the light emitting element OLED. The connection electrode CNE may include a first connection electrode CNE1 and a second connection electrode CNE2.

The first connection electrode CNE1 may be disposed on the third insulating layer INS3 and may be connected to the drain "D" through a first contact hole (e.g., a first contact opening) CH1 defined in the first to third insulating layers INS1 to INS3. The fourth insulating layer INS4 may be disposed on the first connection electrode CNE1. The fifth insulating layer INS5 may be disposed on the fourth insulating layer INS4.

The second connection electrode CNE2 may be disposed on the fifth insulating layer INS5. The second connection electrode CNE2 may be connected to the first connection electrode CNE1 through a second contact hole (e.g., a second contact opening) CH2 defined in the fifth insulating layers INS5. The second connection electrode CNE2 may be disposed on the sixth insulating layer INS6. The first to sixth insulating layers INS1 to INS6 may be inorganic layers or organic layers.

The first electrode AE may be disposed on the sixth insulating layer INS6. The first electrode AE may be connected to the second connection electrode CNE2 through a third contact hole (e.g., a third contact opening) CH3 defined in the sixth insulating layer INS6. A pixel definition layer PDL that exposes a specific portion of the first electrode AE may be disposed on the first electrode AE and the sixth insulating layer INS6. An opening PX_OP for exposing a specific portion of the first electrode AE may be defined in the pixel definition layer PDL.

The hole control layer HCL may be disposed on the first electrode AE and the pixel definition layer PDL. The hole control layer HCL may be disposed in common in the emission part PA and the non-emission part NPA. The hole control layer HCL may include a hole transport layer and a hole injection layer.

The emission layer EML may be disposed on the hole control layer HCL. The emission layer EML may include an organic material and/or an inorganic material. The emission layer EML may generate one of red light, green light, and blue light.

The emission layer EML may be manufactured by the deposition device DPA illustrated in FIG. 1. Deposition materials may be provided onto the substrate SUB through the cell SMK1 of the mask SMK to form an emission layer EML.

The electron control layer ECL may be disposed on the emission layer EML and the hole control layer HCL. The electron control layer ECL may be disposed in common in the emission part PA and the non-emission part NPA. The electron control layer ECL may include an electron transport layer and an electron injection layer.

The second electrode CE may be disposed on the electron control layer ECL. The second electrode CE may be disposed in the pixels PX in common.

A thin film encapsulation layer TFE may be disposed on the light emitting element OLED. The thin film encapsulation layer TFE may be disposed on the second electrode CE to cover the pixel PX. The thin film encapsulation layer TFE may include at least two inorganic layers and an organic layer between the inorganic layers. The inorganic layers may protect pixels PX from moisture/oxygen. The organic layer may protect the pixels PX from foreign substances, such as dust particles.

A first voltage may be applied to the first electrode AE through the transistor TR, and a second voltage having a lower level than that of the first voltage may be applied to the second electrode CE. Excitons may be formed by coupling holes and electrons that are injected into the emission layer EML, and as the excitons transit to a ground state, the light emitting element OLED may emit light.

According to an embodiment of the present disclosure, the deposition materials that scatter in directions other than the direction of the substrate may be recovered and collected.

Furthermore, waste of the deposition material may be reduced or prevented, and the deposition material may be repurified and reused.

Ultimately, the costs of the deposition process may be reduced, and the efficiency of the deposition process may be improved.

Although described above with reference to various embodiments, it will be understood by those skilled in the art that various modifications and changes may be made in the present disclosure without departing from the scope of the present disclosure as defined by the following claims and their equivalents. Furthermore, embodiments of the present disclosure are not intended to limit the present disclosure. All technical ideas within the scope of the following claims and all equivalents thereof should be construed as being included within the scope of the present disclosure.

## Claims

1. A spray device (SPA) comprising:
a crucible (CR) configured to accommodate a deposition material (DPM);
a device frame (SGF) on the crucible (CR);
a nozzle (NZ) in the device frame (SGF) and configured to spray the deposition material (DPM) toward a substrate (SUB); and
a recovery unit (SRP) in the device frame (SGF) and configured to recover the deposition material (DPM) spattering in directions other than the direction toward the substrate (SUB).

2. The spray device (SPA) of claim 1, wherein the recovery unit (SRP) is at a side portion of the device frame (SGF).

3. The spray device (SPA) of claim 2, wherein the recovery unit (SRP) comprises:
a support part (DRB) coupled to the device frame (SGF) and extending in a third direction (DR3); and
a recovery part (URB) connected to an upper portion of the support part (DRB) and configured to recover the deposition material (DPM).

4. The spray device (SPA) of claim 3, wherein the recovery part (URB) protrudes in a direction of the nozzle (NZ).

5. The spray device (SPA) of claim 4, wherein the recovery part (URB) comprises a plurality of pockets (URB1, URB2), and
wherein the plurality of pockets (URB1, URB2) have a height difference with respect to each other along the third direction (DR3).

6. The spray device (SPA) of claim 5, wherein the recovery part (URB) comprises:
a lower pocket (URB2) connected to an upper portion of the support part (DRB) and extending along a first direction (DR1);
a stepped part (URB5) connected to an end of the lower pocket (URB2) and extending along the third direction (DR3);
an upper pocket (URB1) connected to an end of the stepped part (URB5) and extending along the first direction (DR1); and
a pair of side walls (URB3) connected to opposite sides of each of the lower pocket (URB2), the stepped part (URB5), and the upper pocket (URB1), optionally wherein the lower pocket (URB2), the stepped part (URB5), and the upper pocket (URB1) each have a quadrangular plate shape.

7. The spray device (SPA) of any one of claims 3 to 6, wherein the device frame (SGF) forms a plurality of spray areas (SA1, SA2),
wherein the plurality of spray areas (SA1, SA2) are arranged to be divided along a second direction (DR2), and
wherein the nozzle (NZ) is in each of the plurality of spray areas (SA1, SA2), optionally wherein:
the plurality of spray areas (SA1, SA2) are divided into a first spray area (SA1) and a second spray area (SA2),
wherein the first spray area (SA1) defines, from among the plurality of spray areas (SA1, SA2), a spray area in which a deposition material (DPM) having the same substance is sprayed,
wherein the second spray area (SA2) defines, from among the plurality of spray areas (SA1, SA2), a spray area in which a deposition material (DPM) having a different substance is sprayed, and
wherein the recovery unit (SRP) is separated in the first spray area (SA1) and the second spray area (SA2).

8. The spray device (SPA) of claim 6 or claim 7, further comprising a spray guide plate (ALP) on the device frame (SGF) and configured to limit a spray direction of the deposition material (DPM) sprayed from the nozzle (NZ),
wherein a height (HT) of the recovery unit (SRP) is greater than a height (H2) of the spray guide plate (ALP).

9. A deposition device (DPA) comprising:
a chamber (CH);
a substrate stage (STG) in an interior of the chamber (CH) and configured to affix a substrate (SUB);
a mask (SMK) under the substrate stage (STG) and configured to guide a position to which a deposition material (DPM) is deposited on the substrate (SUB);
a barrier plate (PTP) under the mask (SMK);
a spray device (SPA) under the barrier plate (PTP) and configured to spray the deposition material (DPM) toward the substrate (SUB); and
a movement unit (MOV) connected to the spray device (SPA) and configured to move the spray device (SPA),
wherein the spray device (SPA) is configured to recover the deposition material (DPM) spattering in directions other than the direction toward the substrate (SUB).

10. The deposition device (DPA) of claim 9, wherein the spray device (SPA) comprises:
a crucible (CR) configured to accommodate the deposition material (DPM);
a device frame (SGF) on the crucible (CR);
a nozzle (NZ) in the device frame (SGF) and configured to spray the deposition material (DPM) in the direction toward the substrate (SUB);
a spray guide plate (ALP) on the device frame (SGF) and configured to guide a spray direction of the deposition material (DPM); and
a recovery unit (SRP) in the device frame (SGF) and configured to recover the deposition material (DPM) spattering in directions other than the direction toward the substrate (SUB).

11. The deposition device (DPA) of claim 10, wherein the recovery unit (SRP) comprises:
a support part (DRB) coupled to the device frame (SGF) and extending in a third direction (DR3); and
a recovery part (URB) connected to an upper portion of the support part (DRB) and configured to recover the deposition material (DPM).

12. The deposition device (DPA) of claim 11, wherein the recovery part (URB) comprises:
a lower pocket (URB2) connected to an upper portion of the support part (DRB) and extending along a first direction (DR1);
a stepped part (URB5) connected to an end of the lower pocket (URB2) and extending along the third direction (DR3);
an upper pocket (URB1) connected to an end of the stepped part (URB5) and extending along the first direction (DR1); and
a pair of side walls (URB3) connected to opposite sides of each of the lower pocket (URB2), the stepped part (URB5), and the upper pocket (URB1).

13. The deposition device (DPA) of claim 12, wherein an imaginary line (W1) connects an end point of the nozzle (NZ) and an end point of the substrate (SUB), and
wherein a recovery interval (GT) is defined by an interval between an end point of the upper pocket (URB1) and the imaginary line (W1).

14. The deposition device (DPA) of claim 13, wherein the recovery interval (GT) is in a range from 20 mm to 50 mm.

15. The deposition device (DPA) of claim 13 or claim 14, wherein the device frame (SGF) forms a spray area,
wherein the spray area has a first spray area (SA1) and a second spray area (SA2),
wherein the first spray area (SA1) defines a spray area in which a deposition material (DPM) having the same substance is sprayed,
wherein the second spray area (SA2) defines a spray area in which a deposition material (DPM) having a different substance is sprayed, and
wherein the recovery unit (SRP) is separated from the first spray area (SA1) and the second spray area (SA2), optionally wherein:
(i) a height (H1) between a bottom portion of the device frame (SGF) and the barrier plate (PTP) is defined as a reference height,
wherein a height (HT) of the recovery unit (SRP) is defined as a recovery height,
wherein the deposition material (DMP) having the different material is sprayed in the spray areas (SA1, SA2), and
wherein the recovery height of the recovery unit (SRP) is in a range of 46% to 50% compared to the reference height; or
(ii) a height (H1) between a bottom portion of the device frame (SGF) and the barrier plate (PTP) is defined as a reference height,
wherein a height (HT) of the recovery unit (SRP) is defined as a recovery height,
wherein the deposition material (DPM) having the same material is sprayed in the spray areas (SA1, SA2), and
wherein the recovery height of the recovery unit (SRP) is in a range of 46% to 100% compared to the reference height.
